(19) Europäisches Patentamt
European Patent Office
Office européen des brevets

(11) Veröffentlichungsnummer: **0 264 845**
**A2**

(12) # EUROPÄISCHE PATENTANMELDUNG

(21) Anmeldenummer: **87115138.7**

(51) Int. Cl.4: **G03F 7/02**

(22) Anmeldetag: **16.10.87**

(30) Priorität: **20.10.86 US 921291**

(43) Veröffentlichungstag der Anmeldung:
**27.04.88 Patentblatt 88/17**

(84) Benannte Vertragsstaaten:
**AT DE FR GB IT NL**

(71) Anmelder: **HOECHST CELANESE CORPORATION**
**Route 202-206 North**
**Somerville, N.J. 08876(US)**

(72) Erfinder: **Jain, Sangya**
**891 Ardsley Lane**
**Bridgewater New Jersey 08807(US)**
Erfinder: **Chang, Yuh-Loo**
**5 Ledgewood Circle**
**Setauket New York 11733(US)**

(74) Vertreter: **Euler, Kurt Emil, Dr.**
**HOECHST AG - Werk KALLE Patentabteilung**
**Postfach 3540 Rheingaustrasse 190**
**D-6200 Wiesbaden(DE)**

(54) **Positiv arbeitendes mehrschichtiges Aufzeichnungsmaterial.**

(57) Die Erfindung betrifft ein mehrschichtiges Aufzeichnungsmaterial, im wesentlichen bestehend aus einem Träger und mindestens zwei positiv arbeitenden lichtempfindlichen Schichten (Basisschicht und Deckschicht), wobei die lichtempfindliche Basisschicht ein Vernetzungsmittel enthält, und deshalb durch Licht und/oder Wärme ohne die Lichtempfindlichkeit dieser Schicht wesentlich zu reduzieren, vernetzbar ist. Beide lichtempfindlichen Schichten werden mit UV-Licht, allerdings unterschiedlicher Wellenlänge, belichtet und mit einem wäßrig alkalischen Entwickler entwickelt.

Der Vorteil des erfindungsgemäßen Aufzeichnungsmaterials liegt in der hohen Wärmebeständigkeit der Basisschicht, einer nicht notwendigen Sperrschicht zwischen Basis-und Deckschicht, und in der Möglichkeit, beide Schichten mit wäßrig alkalischen Entwicklern entwickeln zu können.

EP 0 264 845 A2

## Positiv arbeitendes mehrschichtiges Aufzeichnungsmaterial

Die vorliegende Erfindung betrifft ein mehrschichtiges Aufzeichnungsmaterial, im wesentlichen bestehend aus einem Träger und mindestens zwei positiv arbeitenden lichtempfindlichen Schichten.

Die Herstellung von positiv arbeitenden lichtempfindlichen Gemischen ist z.B. in den US-A 3,666,473, 4,115,128 und 4,173,470 beschrieben. Neben einem alkalilöslichen Phenolformaldehydharz (Novolak) enthalten diese Gemische als lichtempfindliche Substanz gewöhnlich eine substituierte o-Naphthochinondiazidverbindung. Das Harz und die lichtempfindliche Verbindung werden in einem organischen Lösemittel oder Lösemittelgemisch gelöst und die Lösung als dünner Film bzw. dünne Schicht auf einen für den vorgesehenen Anwendungszweck geeigneten Träger aufgebracht.

Bei der üblichen Anwendung wird diese eine lichtempfindliche Schicht bildmäßig belichtet, so daß eine Maske auf dem Träger entsteht. Der Träger kann dann weiter mit einem geeigneten Ätzmittel geätzt oder es können auf ihm insbesondere Metalle abgeschieden werden. Optischen Bebilderungssystemen sind jedoch Grenzen gesetzt, so daß die Auflösung von feinen Strukturen, in der Größenordnung von 2 µm und darunter, eingeschränkt ist, insbesondere dann, wenn der Träger Rauhigkeiten aufweist. B.J. Lin und T.H.P. Chang haben herausgefunden (J. Vac. Sci. Tech. 1979, Nr. 16, S. 1669), daß die Auflösung weiter verbessert werden kann, wenn man Mehrschichtsysteme zur Herstellung einer PCM-Maske einsetzt.

Bei der bekannten Mehrschichtenlithographie wird der Träger mit einer relativ dicken und daher ebenen lichtempfindlichen Schicht (Basisschicht) bedeckt. Eine weitere lichtempfindliche Schicht, insbesondere eine solche, die das Licht einer anderen Wellenlänge als die Basisschicht absorbiert, wird über die Basisschicht aufgebracht. Diese Deckschicht wird mit einer ihr spezifischen aktinischen Wellenlänge durch eine Kopiermaske belichtet. Das Bild wird mit einem geeigneten Entwickler entwickelt. Das auf der Deckschicht befindliche Bild kann nun als PCM-Maske zur Bebilderung der Basisschicht bei ganzflächiger Belichtung des Systems mit der für die Basisschicht spezifischen aktinischen Wellenlänge verwendet werden.

Bei unerwünschtem gegenseitigen Vermischen oder Verschmieren der beiden lichtempfindlichen Schichten kann eine zusätzliche Sperrschicht zwischen den beiden Schichten vorgesehen sein müssen. Die Sperrschicht kann aus einem organischen Polymeren bestehen, das sich mit keiner der beiden Schichten vermischt, wie z.B. Polyvinylalkohol, oder es kann sich um eine anorganische Schicht handeln, z.B. eine Schicht aus Siliciumoxid oder Siliciumnitrid. Solche Dreischichtensysteme sind aus Gründen der Verarbeitbarkeit weniger günstig als Zweischichtensysteme.

Aufgabe der Erfindung war es daher, ein mehrschichtiges positiv arbeitendes lichtempindliches Aufzeichungsmaterial bereitzustellen, bei dem die lichtempfindlichen Schichten keine zwischen ihnen liegende Sperrschicht benötigen, zur Entwicklung keine organischen Lösemittel verwendet werden müssen, die Basisschicht eine hohe Wärmebeständigkeit aufweist und diese sich in einem wäßrigalkalischen Entwickler nur unwesentlich löst, sowie das entwickelte Bild eine verbesserte Auflösung im Vergleich zu Einschichtensytemen zeigt und andererseits aber im Vergleich zu Dreischichtensystemen einen geringeren Verarbeitungsaufwand beansprucht.

Gelöst wird die Aufgabe durch Bereitstellen eines mehrschichtigen positiv arbeitenden lichtempfindlichen Aufzeichnungsmaterials, im wesentlichen bestehend aus einem Träger und zwei darauf aufgebrachten, positiv arbeitenden lichtempfindlichen Schichten (einer Basisschicht und einer Deckschicht), dadurch gekennzeichnet, daß die lichtempfindliche Basisschicht

A) als lichtempfindliche Verbindung eine Verbindung der allgemeinen Formel I

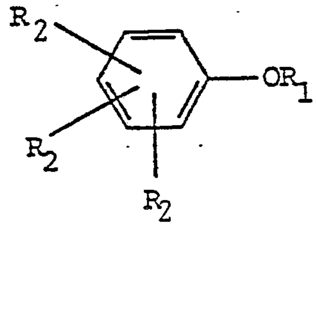

(I)

enthält, worin

$R_1$ 1,2-Benzochinondiazid-4-sulfonyl; 1,2-Naphthochinondiazid-4-sulfonyl oder 1,2-Anthrachinondiazid-4-sulfonyl sowie

$R_2$ gleich oder verschieden sein können und Wasserstoff, Hydroxy, $O-R_3$, $R_4$ oder $-\overset{O}{\overset{\parallel}{C}}-R_4$ und

$R_3$ Alkyl, Aryl, Aralkyl oder $R_1$ sowie

$R_4$ Alkyl, Aryl oder Aralkyl

bedeuten oder eine Verbindung der allgemeinen Formel II

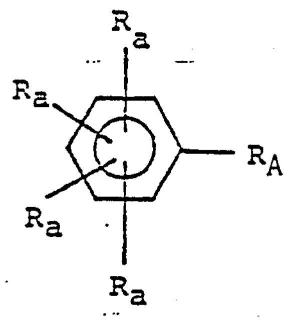

(II)

enthält, worin

$R_A$ Wasserstoff, $-X-R_b$ oder

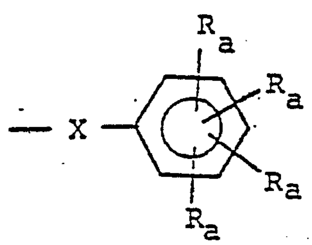

,

X eine Einfachbindung C-C, -O-, -S-, $-SO_2-$, $-\overset{O}{\overset{\parallel}{C}}-$, $-\overset{O}{\overset{\parallel}{C}}-(CH_2)_n$, $-CH_2-\overset{O}{\overset{\parallel}{C}}-(CH_2)_n-$, $-\overset{O}{\overset{\parallel}{C}}-O-$, $-\overset{O}{\overset{\parallel}{C}}-O-(CH_2)_n-$, $CH_2-\overset{O}{\overset{\parallel}{C}}-O-(CH_2)_n-$, $-(CH_2)_n-$oder $CH_3-\underset{|}{\overset{|}{C}}-CH_3$, wobei n für 1 oder 2 steht,

$R_a$ Wasserstoff, -OH, -OY, -OZ, $R_A$ , Halogen, oder eine niedere Alkylgruppe, wobei mindestens eine Gruppe $R_a$ -OY und mindestens eine Gruppe $R_a$-OZ ist, und

$R_b$ Wasserstoff, eine substituierte oder unsubstituierte Alkyl-, Aryl-oder Aralkylgruppe

bedeuten, oder eine Verbindung der allgemeinen Formel III

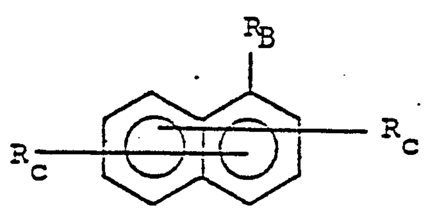

(III)

enthält, worin

$R_B$ Wasserstoff oder

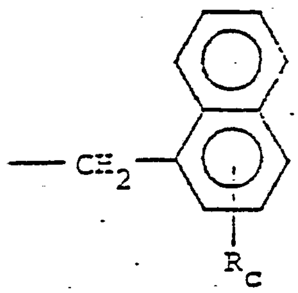

und

$R_c$ Wasserstoff, -OH, -OY oder -OZ ist, wobei mindestens eine Gruppe $R_c$ -OY und mindestens eine Gruppe $R_c$ -OZ

bedeuten, oder eine Verbindung der allgemeinen Formel IV

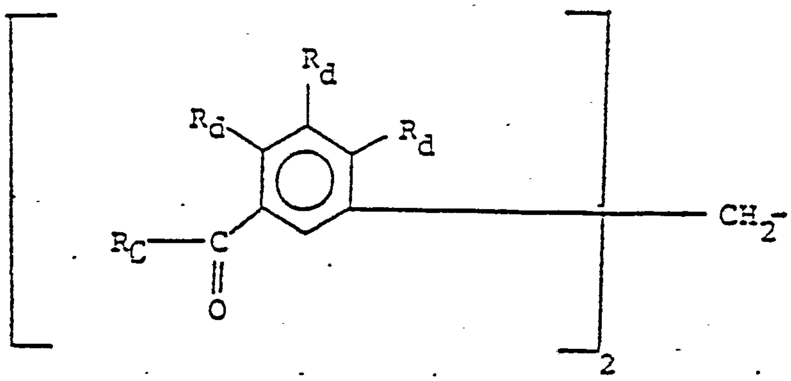

(IV)

enthält, worin

$R_C$ Wasserstoff, eine substituierte oder unsubstituierte Alkyl-oder Arylgruppe und
$R_d$ -OH, -OY oder -OZ ist, wobei mindestens eine Gruppe $R_d$ -OY und mindestens eine Gruppe $R_d$-OZ sowie

in den Verbindungen der allgemeinen Formeln II bis IV

Y 1,2-Naphthochinondiazid-4-sulfonyl und
Z 1,2-Naphthochinondiazid-5-sulfonyl oder -W-$R_5$, wobei
W -CO-oder -$SO_2$-und
$R_5$ substituiertes oder unsubstituiertes Alkyl oder Aryl

bedeuten, sowie

B) als Bindemittel ein Novolak und/oder ein Polyvinylphenol,

C) ein Vernetzungsmittel und

D) ein Lösemittel in der lichtempfindlichen Basisschicht enthalten ist.

Erfindungsgemäß wird ebenso ein Verfahren zur Herstellung eines positiv arbeitenden mehrschichtigen Aufzeichnungsmaterials beschrieben, welches folgende Schritte umfaßt:

a) Herstellung eines lichtempfindlichen Gemischs für die Basisschicht, enthaltend eine der lichtempfindlichen Verbindungen der allgemeinen Formeln I bis IV, als Bindemittel ein Novolak und/oder ein Polyvinylphenolharz, ein Vernetzungsmittel, das in Anwesenheit der bei der Belichtung entstehenden Säure und/oder unter Wärmezufuhr befähigt ist, das Gemisch zu vernetzen, sowie ein Lösemittel,

b) Beschichten des Trägers mit diesem lichtempfindlichen Gemisch sowie Trocknen, so daß eine nicht klebrige lichtempfindliche Basisschicht entsteht,

c) ganzflächiges, nicht bildmäßiges Belichten der Basisschicht mit aktinischer Strahlung und Wärmezufuhr, um die Schicht teilweise zu vernetzen, ohne jedoch die Lichtempfindlichkeit der Schicht im wesentlichen zu verringern,

d) Beschichten der vernetzten lichtempfindlichen Basisschicht mit einem weiteren positiv arbeitenden lichtempfindlichen Gemisch, enthaltend ein o-Chinondiazid, als Bindemittel ein Novolakharz und/oder ein Polyvinylphenolharz (= lichtempfindliche Deckschicht),

e) Bildmäßiges Belichten der lichtempfindlichen Deckschicht mit für diese Schicht geeigneter aktinischen Strahlung und Entwickeln zu einer Bildmaske,

f) Belichten der lichtempfindlichen Basisschicht mit für diese Schicht geeigneter aktinischer Strahlung und Entwickeln der belichteten Bereiche auch dieser Schicht.

Vorzugsweise enthält die lichtempfindliche Basisschicht 1 bis 25 Gew.-%, bezogen auf das Gewicht der festen Bestandteile des Gemischs, einer lichtempfindlichen Verbindung der Formeln I bis IV, 75 bis 99 Gew.-%, bezogen auf das Gewicht der festen Bestandteile des Gemischs, des Bindemittels sowie 0,5 bis 20 Gew.-%, ebenfalls bezogen auf das Gewicht der festen Bestandteile des Gewichts, des Vernetzungsmittels.

Das erfindungsgemäße, mehrschichtige, positiv arbeitende lichtempfindliche Aufzeichnungsmaterial hat gegenüber üblichen Zweischichtensystemen den Vorteil, daß in den Entwicklungsschritten keine organischen Lösemittel verwendet werden müssen. Beide Schichten dieses Mehrschichtensystems können mit wäßrig-alkalischen Entwicklern entwickelt werden. Die Basisschicht löst sich nur unverhältnismäßig wenig im Entwickler der Deckschicht, da sie teilweise vernetzt ist. Als Zweischichtensystem benötigt es einen geringeren Verarbeitungsaufwand als ein Dreischichtensystem. Die Basisschicht hat auch ohne einen weiteren Verarbeitungsschritt eine größere Wärmebeständigkeit als eine in herkömmlicher Weise positiv bebilderte lichtempfindliche Schicht, da sie teilweise vernetzt ist. Diese erhöhte Wärmebeständigkeit ist von besonderer Bedeutung, um einen Ätzvorgang durchführen zu können, bei dem Temperaturen im Bereich von 150° C erreicht werden können.

Durch die Teilvernetzung der lichtempfindlichen Basisschicht ergeben sich für das gesamte mehrschichtige Aufzeichnungsmaterial völlig unerwartete Verbesserungen im Vergleich zu beim Flachdruck üblichen Verarbeitungsverfahren. Zu den Vorteilen zählen eine Verbesserung des Verhältnisses zwischen Belichtungs-energie und resultierender Linienbreite, eine Verbesserung der Auflösung des entwickelten Bildes, das weitestgehende Vermeiden von Veränderungen in den Linienbreiten bedingt durch die Reflexion des Lichtes und ein vollständig wäßrig entwikkelbares System.

Von den durch die allgemeine Formel II dargestellten Verbindungen wurden solche bevorzugt, in denen

$R_a$ Wasserstoff, -OH, OY, OZ, Halogen, vorzugsweise Chlor oder Brom, oder eine niedere Alkylgruppe, vorzugsweise mit 1 bis 4 C-Atomen, wobei mindestens eine Gruppe $R_a$ -OY und mindestens eine Gruppe $R_a$-OZ ist und

$R_b$ Wasserstoff, eine substituierte oder unsubstituierte Alkyl-, Aryl-oder Aralkylgruppe, wobei die Alkylgruppen 1 bis 20 C-Atome, insbesondere 1 bis 12 C-Atome, die Arylgruppen Phenyl oder Naphthyl, sind und als Substituenten jeweils niedere Alkylgruppen mit 1 bis 4 C-Atomen, niedere Alkoxygruppen mit 1 bis 4 C-Atomen oder Halogenatomen, vorzugsweise Chlor oder Brom, in Frage kommen,

bedeuten.

Von den durch die allgemeine Formel IV dargestellten Verbindungen werden solche bevorzugt, in denen

$R_d$ -OH, -OY oder -OZ ist, wobei mindestens eine Gruppe $R_d$ -OY und mindestens eine Gruppe $R_d$ -OZ ist,

$R_C$ Wasserstoff oder eine substituierte oder unsubstituierte Alkyl-oder Arylgruppe, die verzweigt oder geradkettig sein können, wobei die Alkylgruppen 1 bis 20 C-Atome aufweisen können, die vorzugsweise einkernigen und 6 bis 10 C-Atome aufweisenden Arylgruppen können mit niederen Alkyl-oder Alkoxygrup pen mit 1 bis 4 C-Atomen oder mit Halogen substituiert sein, sind besonders bevorzugt, insbesondere wenn sie eine Phenylgruppe darstellen,

bedeuten.

In den Verbindungen der allgemeinen Formeln II bis IV ist ebenso bevorzugt, wenn

$R_5$ substituiertes oder unsubstituiertes Alkyl oder Aryl bedeutet, wobei im Falle von Alkyl dieses geradkettig oder verzweigt sein kann und mit Halogen, insbesondere Chlor oder Brom, oder Alkoxygruppen mit 1 bis 4 C-Atomen substituiert sein kann, wobei die Alkylgruppen 1 bis 20 C-Atome aufweisen, im Falle von Aryl

dieses vorzugsweise einkernig ist, 6 bis 10 C-Atome aufweist und mit niederem Alkyl, Alkoxygruppen mit jeweils 1 bis 4 C-Atomen oder mit Halogen, insbesondere Chlor oder Brom, substituiert sein kann, bevorzugt ist allerdings Phenyl. Alkyl ist gegenüber Aryl besonders bevorzugt, insbesondere Alkylgruppen mit 1 bis 6 C-Atomen.

Phenolverbindungen, die den Verbindungen der allgemeinen Formel II zugrunde liegen, sind z.B.: hydroxygruppentragende Benzolverbindungen, wie z.B. 1,2-Dihydroxybenzol, 1,3-Dihydroxybenzol, 1,4-Dihydroxybenzol, 1,2,3-Trihydroxybenzol, 1,2,4-Trihydroxybenzol, 1,3,5-Trihydroxybenzol und dergleichen;
Dihydroxybenzophenone, wie z.B. 2,2'-Dihydroxybenzophenon, 2,3'-Dihydroxybenzophenon, 2,4-Dihydroxybenzophenon, 2,4'-Dihydroxybenzophenon, 2,5-Dihydroxybenzophenon, 3,3'-Dihydroxybenzophenon, 4,4'-Dihydroxybenzophenon und dergleichen;
Trihydroxybenzophenone, wie z.B. 2,2',6-Trihydroxybenzophenon, 2,3,4-Trihydroxybenzophenon, 2,4,4'-Trihydroxybenzophenon, 2,4,6-Trihydroxybenzophenon, 3,4,5-Trihydroxybenzophenon und dergleichen;
Tetrahydroxybenzophenone, wie z.B. 2,2',3,4-Tetrahydroxybenzophenon, 2,2',4,4'-Tetrahydroxybenzophenon, 2,2',4,6'-Tetrahydroxybenzophenon, 2,2',5,6'-Tetrahydroxybenzophenon, 2,3',4,4'-Tetrahydroxybenzophenon, 2,3',4,6-Tetrahydroxybenzophenon, 2,4,4',6-Tetrahydroxybenzophenon, 3,3',4,4'-Tetrahydroxybenzophenon und dergleichen;
Pentahydroxybenzophenone;
Hexahydroxybenzophenone;
Dihydroxy-und Trihydroxyphenylalkylketone, wie z.B. 2,4-Dihydroxyphenylalkylketone, 2,5-Dihydroxyphenylalkylketone, 3,4-Dihydroxyphenylalkylketone, 3,5-Dihydroxyphenylalkylketone, 2,3,4-Trihydroxyphenylalkylketone, 3,4,5-Trihydroxyphenylalkylketone, 2,4,6-Trihydroxyphenylalkylketone und dergleichen, wobei die Alkylgruppe vorzugsweise 1 bis 12 C-Atome aufweist, wie z.B. Methyl, Ethyl, Butyl, n-Hexyl, Heptyl, Decyl, Dodecyl und dergleichen;
Dihydroxyphenylaralkylketone;
Trihydroxyphenylaralkylketone;
Dihydroxydiphenyle;
Trihydroxydiphenyle, wie z.B. 2,2',4-Trihydroxydiphenyl; Tetrahydroxydiphenyle, wie z.B. 2,2',4,4'-Tetrahydroxydiphenyl;
Dihydroxydiphenyloxide;
Dihydroxydibenzyloxide;
Dihydroxydiphenylalkane, vorzugsweise niedere Alkane, wie z.B. Methan, Ethan, Propan und dergleichen;
Dihydroxybenzoesäuren;
Trihydroxybenzoesäuren;
Dihydroxy-und Trihydroxybenzoesäurealkylester, wobei die Alkylgruppe vorzugsweise 1 bis 12 C-Atome aufweist, wie z.B. n-Butyl-2,4-, -2,5-, -3,4-und -3,5-dihydroxybenzoat, 2,4,4-Trimethylpentyl-2,4-dihydroxybenzoat und dergleichen;
Dihydroxy-und Trihydroxybenzoesäurephenylester;
Dihydroxy-, Trihydroxy-und Tetrahydroxydiphenylsulfide, wie z.B. 4,4'-Dihydroxydiphenylsulfid;
Dihydroxydiphenylsulfone;
Dihydroxy-und Trihydroxyphenylnaphthylketone, wie z.B. 2,3,4-Trihydroxyphenylnaphthylketon und dergleichen.

Verbindungen, die der allgemeinen Formel II zugrunde liegen und in denen mindestens eine Gruppe $R_a$ ein Halogenatom oder eine niedere Alkylgruppe ist, sind z.B.:
2,4-Dihydroxy-3,5-dibrombenzophenon;
5-Brom-2,4-dihydroxybenzoesäure und -ester;
2,4,2',4'-Tetrahydroxy-3,5,3',5'-tetrabromdiphenyl;
4,4'-Dihydroxy-2,2'-dimethyl-5,5'-di-tert.-butyldiphenyl;
4,4'-Dihydroxy-2,2'-dimethyl-5,5'-di-tert.-butyldiphenylsulfid;
2,4,2',4'-Tetrahydroxy-3,5,3',5'-tetrabromdiphenylsulfon und dergleichen.

Die bevorzugten Phenolverbindungen, die der allgemeinen Formel II zugrunde liegen, sind die hydroxylgruppentragenden Benzophenone, ganz besonders bevorzugt sind die Trihydroxybenzophenone.

Phenolverbindungen, die der allgemeinen Formel III zugrundeliegen, sind z.B.:
Dihydroxynaphthaline, wie z.B. 1,2-Dihydroxynaphthalin, 1,4-Dihydroxynaphthalin, 1,5-Dihydroxynaphthalin, 1,6-Dihydroxynaphthalin, 1,7-Dihydroxynaphthalin, 1,8-Dihydroxynaphthalin, 2,3-Dihydroxynaphthalin, 2,6-Dihydroxynaphthalin, 2,7-Dihydroxynaphthalin und dergleichen;
Dihydroxydinaphthylmethane, wie z.B. 2,2'-Dihydroxydinaphthylmethan und dergleichen.

Die Dihydroxynaphthylene sind bevorzugt. Dabei können die Hydroxylgruppen der Dihydroxynaphthylene entweder am gleichen Kern oder an verschiedenen Kernen der Naphthalingruppierung stehen.

Phenolverbindungen, die der allgemeinen Formel IV zugrunde liegen, sind z.B.
Bis-(3-benzoyl-4,5,6-trihydroxyphenyl)-methan;
Bis-(3-acetyl-4,5,6-trihydroxyphenyl)-methan;
Bis-(3-propionyl-4,5,6-trihydroxyphenyl)-methan;
Bis-(3-butyryl-4,5,6-trihydroxyphenyl)-methan;
Bis-(3-hexanoyl-4,5,6-trihydroxyphenyl)-methan;
Bis-(3-heptanoyl-4,5,6-trihydroxyphenyl)-methan;
Bis-(3-decanoyl-4,5,6-trihydroxyphenyl)-methan;
Bis-(3-octadecanoyl-4,5,6-trihydroxyphenyl)-methan und dergleichen.

Zu den nicht lichtempfindlichen organischen Säurehalogeniden der Formel W-$R_5$ zählen beispielsweise:
Alkylsulfonylhalogenide, wie z.B. Methansulfonylchlorid, Ethansulfonylchlorid, Propansulfonylchlorid, n-Butansulfonylchlorid, Dodecansulfonylchlorid und dergleichen;
Arylsulfonylchloride, wie z.B. Benzolsulfonylchloride, Naphthalinsulfonyl-chloride und dergleichen;
Acylhalogenide, wie z.B. Acetylchlorid, Butanoylchlorid, Valerylchlorid, Benzoylchlorid, Benzoylbromid, Naphthoylchloride und dergleichen.

Die bevorzugten nicht lichtempfindlichen organischen Säurehalogenide sind niedere Alkylacylhalogenide mit 1 bis 6 C-Atomen sowie Benzolsulfonylhalogenide und Benzoylhalogenide. Diese Säurehalogenide können gegebenfalls substituiert sein.

Bei dem Vernetzungsmittel handelt es sich um eine Verbindung, die in Anwesenheit der bei der Belichtung des Diazids mit aktinischer Strahlung freigesetzten Säuremenge und -stärke fähig ist, das obengenannte Novolak-, Paravinylphenol-oder Polyvinylphenolharz zu vernetzen. Dies geschieht unter Zuführung von Wärme, die so hoch ist, daß die freigesetzte Säure die Vernetzung auslösen kann, jedoch nicht hoch genug, um das Diazid zu zersetzen. Zu der allgemeinen Klasse solcher Verbindungen zählen diejenigen, die unter den genannten Säure-und Wärmebedingungen ein Carboniumion bilden können. Die bevorzugten Verbindungen sind Dimethylolparakresol, wie es in US-A 4,404,272 beschrieben ist, Methylmethoxydiphenylether, Melaminformaldehydharze und -verbindungen sowie entsprechende alkylierte Verbindungen mit 1 bis etwa 3 Monomereinheiten, z.B. Hexamethylolmelaminhexamethylether, Resolharz und Epoxykresolnovolakharz.

In einigen Fällen besitzen diese Additive eine ausreichende Reaktionsfähigkeit, so daß zum Auslösen der Vernetzung keine Belichtung mit aktinischer Strahlung, sondern nur eine Wärmebehandlung erforderlich ist.

Die Resolharze entsprechen der allgemeinen Formel V,

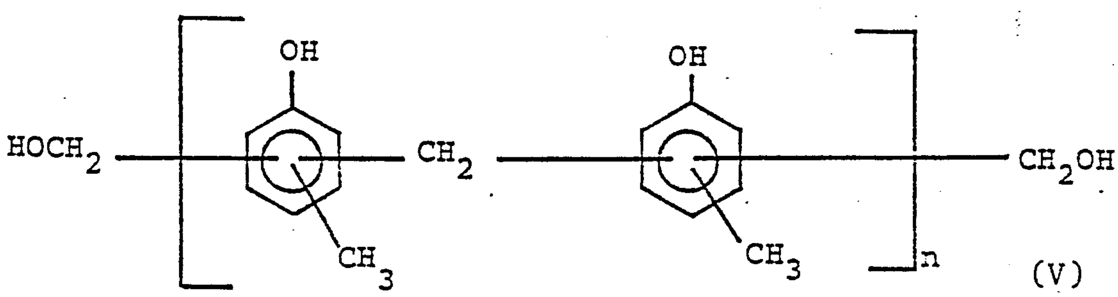

(V)

worin n = 1-15 bedeutet.

Die Epoxykresolnovolakharze entsprechen der allgemeinen Formel VI,

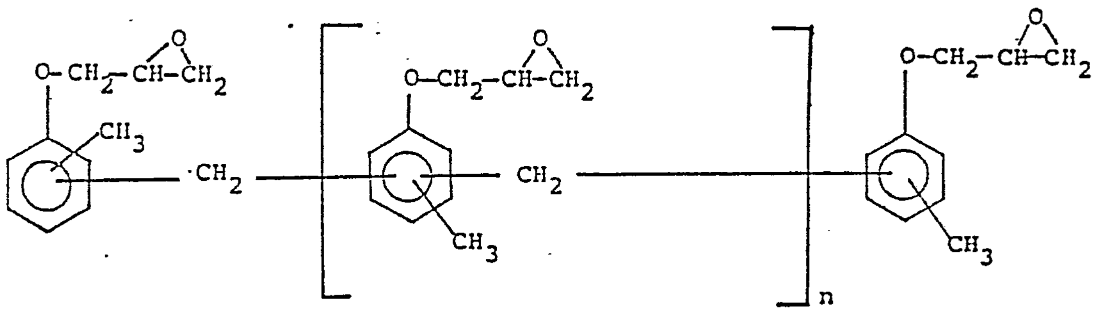

(VI)

worin n = 1-10 bedeutet.

Die Erfindung betrifft ein mehrschichtiges lichtempfindliches Aufzeichnungsmaterial, bei dem auf einen Träger eine lichtempfindliche Basisschicht aufgebracht ist. Bei der Basisphotoresistschicht muß es sich um eine Schicht handeln, die in einem kontrollierbaren Maße vernetzbar ist. Für diesen Zweck werden die in den U.S.-Patentanmeldungen Serial No. 764,700 vom 12. August 1985, Nr. 889,032 vom 23. Juli 1986 und Nr. 895,609 vom 11. August 1986 beschriebenen Gemische bevorzugt.

Bei diesen Gemischen kommt es zu einer Umkehr von einem positiv arbeitenden zu einem negativ arbeitenden System, wenn das Gemisch bzw. die daraus entstehende Basisschicht vor dem Auftragen der lichtempfindlichen Deckschichten belichtet ist, und zwar mit einer Belichtungsenergie von etwa 5 bis 50 $mJ/cm^2$, vorzugsweise 5 bis 40 $mJ/m^2$, und nach dem Belichten eine thermische Nachhärtung durchgeführt wird. Die Belichtungsenergie und die Temperatur der thermischen Nachhärtung bestimmen das Ausmaß der Vernetzung und somit auch die Löslichkeit der nun negativen Basisschicht. Wenn nicht nachgehärtet wird, verhält sich diese Schicht wie eine normal arbeitende positive Schicht.

Die Vernetzung kann auch allein durch thermisches Härten ohne Belichtung eingeleitet werden, insbesondere bei Temperaturen von 90 bis 160° C, wenn ein geeignetes Vernetzungsmittel verwendet wird, das keine durch Licht erzeugten Säuren zur Einleitung der Vernetzung benötigt.

Erfindungswesentlich ist, daß für die Vernetzung solche Bedingungen angewendet werden, bei denen nach dem Aufbringen der lichtempfindlichen Deckschicht im wesentlichen kein Vermischen der Komponenten beider lichtempfindlichen Schichten miteinander festzustellen ist.

Die Basisschicht wird bei einer Temperatur von etwa 20 bis 100° C thermisch konditioniert, bei der das Lösemittel weitgehend aus der Schicht entfernt wird und das Gemisch nicht mehr klebrig ist. Anschließend wird die Schicht mit UV-Licht ganzflächig belichtet und soweit thermisch gehärtet, daß das Material ausreichend vernetzt ist, um beim Auftragen der lichtempfindlichen Deckschicht ein Vermischen der Schichten zu vermeiden. Die Deckschicht kann bei einer aktinischen Wellenlänge von z.B. 300 bis 410 nm belichtet werden.

Wenn der Träger stark reflektierend ist oder eine gewisse Rauhigkeit aufweist, kann dem lichtempfindlichen Gemisch der Basisschicht ein Farbstoff zugesetzt werden. Die Absorption des Farbstoffs sollte bei der gleichen Wellenlänge liegen, wie sie für die bildmäßige Belichtung der Deckschicht verwendet wird, und die Farbstoffkonzentration sollte so hoch sein, daß bei der Belichtung der Deckschicht Reflexionen vom Träger ausgeschlossen sind.

Die auf der vernetzten Basisschicht aufgebrachte lichtempfindliche Deckschicht wird mit Licht bei einer aktinischen Wellenlänge belichtet, die nicht von der lichtempfindlichen Basisschicht absorbiert wird. Das kann jede beliebige Wellenlänge sein, mit Ausnahme des Bereichs von 300 bis 410 nm. Die Wellenlänge könnte z.B. 436 nm betragen.

Um dies zu erreichen, kann der lichtempfindlichen Deckschicht ein Farbstoff zugesetzt werden, der als Belichtungsmaske für die Basisschicht wirkt, d.h. ein Farbstoff, der zwischen 300 und 410 nm absorbiert. Die Konzentration dieses Farbstoffs sollte insbesondere ausreichen, um mit der gewählten Schichtdicke von 0,5 µm bis 1 µm bei der Belichtungswellenlänge für die Basisschicht eine Durchlässigkeit von 1% nicht zu überschreiten und somit die Deckschicht als Belichtungsmaske wirkt.

Die Deckschicht kann durch eine Maske z.B. mit einer Quecksilberhochdrucklampe bei 436 nm bildmäßig belichtet werden. Das Bild wird dann mit einem wäßrig-alkalischen Entwickler entwickelt. Anschließend wird das gesamte System mit der aktinischen Wellenlänge der Basisschicht ganzflächig belichtet. Die Wellenlänge des Lichts soll so gewählt sein, daß das Licht von dem Farbstoff in der noch verbliebenen Deckschicht ausreichend absorbiert wird, um die Durchlässigkeit in den durch die Deckschicht maskierten Bereichen auf unter 1 % zu reduzieren.

Andererseits muß die Belichtungsenergie so hoch sein, um genügend lichtempfindliche Naphthochinonverbindungen in Indencarbonsäuren umzuwandeln und so die Unlöslichkeit der zuvor teilvernetzen Basisschicht rückgängig zu machen. Belichtungsenergien von etwa 100 mJ/cm$^2$ bis etwa 300 mJ/cm$^2$ reichen hierfür aus.

Auch die Basisschicht wird dann mit einem wäßrig-alkalischen Entwickler entwickelt. Auf diese Weise wird das Bild der Belichtungsmaske "positiv" auf den Träger übertragen, wenn die Deckschicht ebenso eine positiv arbeitende Schicht ist.

Das lichtempfindliche Gemisch der Basisschicht enthält ein Lösemittel, ein Vernetzungsmittel, ein in wäßrig-alkalischer Lösung lösliches Bindemittel und eine o-Chinondiazid-4-sulfonylgruppen enthaltende lichtempfindliche Verbindung.

Zu den als Bindemitteln verwendeten Harzen gehören die Novolake und die Polyvinylphenole. Die Herstellung der in den lichtempfindlichen Gemischen verwendbaren Novolak harze ist bekannt. Ein Verfahren zur Herstellung der Novolake ist in "Chemistry and Application of Phenolic Resins" von A. Knop und W. Scheib, Springer Verlag, New York, 1979, Kapitel 4, beschrieben. Polyvinylphenole sind aus den US-A 3,869,292 und 4,439,516 bekannt.

Auch der Einsatz von o-Chinondiaziden ist dem Fachmann bekannt. ("Light Sensitive Systems" von J. Kosar, Verlag John Wiley & Sons, New York, 1965, Kapitel 7.4). Von den lichtempfindlichen Verbindungen, zu denen auch Komponenten der im erfindungsgemäßen Gemisch enthaltenen zählen, sind vorzugsweise substituierte Naphthochinondiazide, die üblicherweise in positiv arbeitenden lichtempfindlichen Gemischen verwendet werden, zu nennen. Derartige lichtempfindliche Verbindungen sind z.B. aus den US-A 2,797,213; 3,106,465; 3,148,983; 3,130,047; 3,201,329; 3,785,825 und 3,802,885 bekannt.

Als lichtempfindliche Verbindung der allgemeinen Formel I für die lichtempfindliche Basisschicht wird ein 1,2-Chinondiazid-4-sulfonsäureester eines Phenolderivats eingesetzt. Die Anzahl der annellierten Ringe - scheint für diese Erfindung nicht von Bedeutung zu sein, dagegen ist die Stellung der Sulfonylgruppe wichtig. D.h. man kann Benzochinone, Naphthochinone oder Anthrachinone verwenden, solange das Sauerstoffatom in Position 1, die Diazogruppe in Position 2 und die Sulfonylgruppe in Position 4 steht. Desgleichen scheint die Art der Phenolkomponente, an die das Chinondiazid gebunden ist, nicht wichtig zu sein. Es kann sich z.B. um ein Cumylphenolderivat gemäß US-A 3,640,992 oder um ein Mono-, Di-oder Trihydroxyphenylalkylketon oder -benzophenon handeln (US-A 4,499,171).

Geeignete lichtempfindliche Verbindungen der allgemeinen Formel I sind z.B. 1,2-Naphthochinondiazid-4-sulfonylchlorid, das mit Phenolverbindungen, wie z.B. Hydroxybenzophenonen, vorzugsweise Trihydroxybenzophenon, insbesondere 2,3,4-Trihydroxybenzophenon kondensiert ist; 2,3,4-Trihydroxyphenylpentylketon-1,2-naphthochinondiazid-4-sulfonsäuretriester oder andere Alkylphenole; 2,3,4-Trihydroxy-3'-methoxybenzophenon-1,2-naphthochinondiazid-4-sulfonsäuretriester; 2,3,4-Trihydroxy-3'-methylbenzophenon-1,2-naphthochinondiazid-4-sulfonsäuretriester und 2,3,4-Trihydroxybenzophenon-1,2-naphthochinondiazid-4-sulfonsäuretriester.

Weitere lichtempfindliche Verbindungen nach den allgemeinen Formeln II bis IV für die Basisschicht des erfindungsgemäßen lichtempfindlichen Mehrschichtensystems lassen sich durch Kondensation von Phenolverbindungen mit einer Mischung aus einem 1,2-Naphthochinondiazid-4-sulfonylhalogenid (1) und einem 1,2-Naphthochinondiazid-5-sulfonylhalogenid (2) und/oder einem organischen nicht lichtempfindlichen Säurehalogenid herstellen. Das Molverhältnis zwischen dem Anteil an dem 4-Sulfonylhalogenid und dem Anteil an dem 5-Sulfonylhalogenid und/oder dem organischen Säurehalogenid in dem Gemisch kann im Bereich von etwa 1:1 bis 39:1, vorzugsweise von etwa 4:1 bis 19:1, insbesondere von etwa 85:15 bis 93:7 liegen. Es kann beispielsweise 1 mol 2,3,4-Trihydroxybenzophenon mit einer Mischung aus 2,7 mol Diazoniumverbindung 1 und 0,3 mol Diazoniumverbindung 2 (Verhältnis 9:1) kondensiert werden, wobei sich eine lichtempfindliche Verbindung der folgenden Formel ergibt:

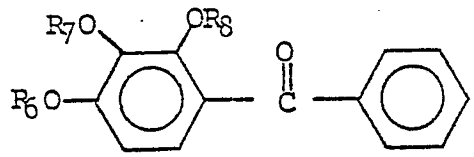

worin $R_6$, $R_7$ und $R_8$ unabhängig voneinander entweder 1,2-Naphthochinondiazid-4-sulfonyl oder 1,2-Naphthochinondiazid-5-sulfonyl sein können.

Die lichtempfindlichen Verbindungen können durch Kondensation von Phenolverbindungen mit der Diazoniumverbindung 1 und Diazoniumverbindung 2 und/oder dem nicht lichtempfindlichen organischen Säurehalogenid erhalten werden. Die Komponente Diazoniumverbindung 1 und die Komponente Diazoniumverbindung 2 und/oder das organische Säurehalogenid können entweder nacheinander oder gleichzeitig mit den Phenolverbindungen kondensiert werden.

Die Mischung aus Diazoniumverbindung 1 mit Diazoniumverbindung 2/organischem Säurehalogenid kann vorzugsweise in stöchiometrischen Mengen mit den hydroxylgruppentragenden Verbindungen umgesetzt werden. Die Phenolverbindungen müssen jedoch nicht vollständig verestert werden, d.h. es können geringere als stöchiometrische Mengen der Diazonium-bzw. der nicht lichtempfindlichen organischen Säurehalogenidverbindungen mit den Phenolverbindungen kondensiert werden, sofern das Molverhältnis zwischen den umgesetzten Verbindungen Diazo 1 und Diazo 2 und/oder organischem Säurehalogenid innerhalb der oben angegebenen Bereiche liegt. Die Gesamtmenge an Diazoniumverbindung 1 und Diazoniumverbindung 2 und/oder organischem Säurehalogenid, die mit einer Phenolverbindung umgesetzt wird, soll ausreichen, um ein lichtempfindliches Gemisch zu ergeben, das die Auflösungsgeschwindigkeit eines alkalilöslichen Harzes hemmen kann.

Zur Herstellung des lichtempfindlichen Gemischs der Basisschicht werden die Bestandteile dieses Gemischs in einem geeigneten Lösemittelgemisch gelöst. In der bevorzugten Ausführungsform ist das Harz vorwiegend in einem Anteil von etwa 75 bis 99 Gew.-%, bezogen auf das Feststoffgewicht, d.h. bezogen auf die nichtlösenden Teile des Gemischs, enthalten. Vorzugsweise liegt der Harzanteil im Bereich von etwa 80 bis 90 Gew.-%, insbesondere bevorzugt von etwa 82 bis 85 Gew.-%, bezogen auf das Feststoffgewicht des Gemisches.

Der Anteil an Diazoverbindung 1 in dieser Schicht liegt vorwiegend im Bereich von etwa 1 bis 25 Gew.-%, bezogen auf das Feststoffgewicht des Gemischs. Vorzugsweise liegt deren Anteil im Bereich von etwa 1 bis 20 Gew.-%, insbesondere bevorzugt von etwa 10 bis 18 Gew.-%, bezogen auf das Feststoffgewicht.

Der Anteil des Vernetzungsmittels in dieser Schicht liegt vorwiegend im Bereich von etwa 0.5 bis 20 Gew.-%, bezogen auf das Feststoffgewicht. Vorzugsweise liegt dessen Anteil im Bereich von etwa 1 bis 10 Gew.-%, insbesondere bevorzugt von etwa 3 bis 6 Gew.-%.

Bei der Herstellung des Gemischs löst man Harz, Vernetzungsmittel und Diazoverbindung in einem Lösemittel, wie z.B. Propylenglykolalkyletheracetat, Butylacetat, Xylol, Ethylenglykolmonoethyletheracetat und Propylenglykolmethyletheracetat, Propylenglykolalkylether, z.B. Propylenglykolmethylether oder in Mischungen, die u.a. aus den vorgenannten Lösemitteln bestehen.

Bevor die Lösung aus Harz, lichtempfindlicher Verbindung, Vernetzungsmittel und Lösemittel auf einen Träger aufgebracht wird, können ihr noch Additive, wie z.B. Farbmittel, Farbstoffe, Verlaufmittel, Weichmacher, Haftvermittler, Entwicklungsbeschleuniger, Lösemittel und Tenside, wie z.B. nichtionische Tenside, zugegeben werden.

Als Farbstoffe können dem Gemisch z.B. Methylviolett 2B (C.I. 42 535), Kristallviolett (C.I. 42 555), Malachitgrün (C.I. 42 000), Viktoriablau B (C.I. 44 045) und Neutralrot (C.I. 50 040) in einer Menge von 1 bis 10 Gew.-%, bezogen auf das Feststoffgewicht des Gemischs, zugesetzt werden. Die Farbstoffzusätze tragen zu einer höheren Auflösung bei, indem sie die Lichtrückstreuung vom Träger verhindern.

Verlaufmittel können in einer Menge bis zu 5 Gew.-%, bezogen auf das Feststoffgewicht, zugesetzt werden.

Geeignete Weichmacher sind z.B. Phosphorsäure-tri-(β-chlorethyl)-ester, Stearinsäure, Dicampher, Polypropylen, Acetalharze, Phenoxyharze und Alkylharze, die in einer Menge von 1 bis 10 Gew.-%, bezogen auf das Feststoffgewicht, zugesetzt werden können. Die Weichmacherzusätze verbessern die Beschichtungseigenschaften des Materials und ermöglichen das Aufbringen des Gemischs auf den Träger als glatte und gleichmäßig dicke Schicht.

Als Haftvermittler können z.B. β-(3,4-Epoxycyclohexyl)ethyltrimethoxysilan, p-Methyldisilanmethylmethacrylat, Vinyltrichlorsilan und γ-Aminopropyltriethoxysilan in einer Menge bis zu 4 Gew.-%, bezogen auf das Feststoffgewicht des Gemischs, zugesetzt werden.

Geeignete Entwicklungsbeschleuniger sind z.B. Pikrinsäure, Nicotinsäure oder Nitrozimtsäure, die in einer Menge bis zu 20 Gew.-%, bezogen auf das gemeinsame Gewicht von Harz und Feststoffen, zugesetzt werden können. Diese Beschleuniger führen zu einer erhöhten Löslichkeit der lichtempfindlichen Schicht, sowohl in den belichteten als auch in den unbelichteten Bereichen. Sie werden deshalb für solche Anwendungen eingesetzt, bei denen die Entwicklungsgeschwindigkeit vorrangig ist, selbst wenn dabei ein gewisses Maß an Kontrast verlorengeht, d.h. die belichteten Bereiche der Schicht lösen sich zwar rascher in dem Entwickler, gleichzeitig verursachen die Entwicklungsbeschleuniger aber auch einen größeren Verlust an unbelichteten Schichtbereichen.

Die Beschichtungslösemittel können im Gesamtgemisch in einem Anteil von bis zu 95 Gew.-%, bezogen auf das Feststoffgewicht der Schicht, enthalten sein.

Geeignete nichtionische Tenside sind z.B. Nonylphenoxypoly(ethylenoxy)-ethanol, Octylphenoxy-(ethylenoxy)-ethanol und Dinonylphenoxypoly(ethylenoxy)-ethanol, die in einer Menge bis zu 10 Gew.-%, bezogen auf das Feststoffgewicht der Schicht, zugegeben werden können.

Das vorbereitete lichtempfindliche Gemisch kann nach einem in der Photoresisttechnik üblichen Verfahren auf einen Träger aufgebracht werden, z.B. durch Tauchen, Sprühen oder durch Schleuderbeschichten. Beim Schleuderbeschichten kann z.B. der prozentuale Feststoffgehalt der Resistlösung so eingestellt werden, daß sich bei Verwendung eines bestimmten Schleudervorrichtungstyps und einer bestimmten für den Schleudervorgang vorgesehenen Zeitspanne eine Beschichtung in der gewünschten Dicke ergibt. Geeignete Träger sind z.B. Silicium, Aluminium oder polymere Harze, Siliciumdioxid, dotiertes Siliciumdioxid, Siliciumnitrid, Tantal, Kupfer, Polysilicium, Keramik sowie Mischungen aus Aluminium und Kupfer.

Die nach dem oben beschriebenen Verfahren hergestellten Photoresistbeschichtungen eignen sich insbesondere für die Anwendung auf Siliciumwafern, die mit thermisch gezüchtetem Siliciumoxid beschichtet sind, so wie sie bei der Herstellung von Mikroprozessoren und anderen Bauelementen für miniaturisierte Schaltkreise eingesetzt werden. Es kann auch ein Aluminium/Aluminiumoxid-Wafer verwendet werden. Der Träger kann ebenso aus verschiedenen polymeren Harzen, insbesondere transparenten Polymeren, wie z.B. Polyestern, bestehen.

Nachdem das Gemisch der lichtempfindlichen Basisschicht auf den Träger aufgebracht worden ist, wird der Träger thermisch konditioniert. Durch diese thermische Konditionierung soll die Konzentration von Lösemittelresten im Photoresist reduziert und gesteuert werden, wobei jedoch kein wesentlicher thermischer Abbau der lichtempfindlichen Verbindung verursacht werden soll. Im allgemeinen möchte man die Lösemittelkonzentration auf das Mindestmaß reduzieren. Deshalb wird diese erste thermische Konditionierung so durchgeführt, daß sich der Lösemittelgehalt der Schicht durch Verdampfen reduziert und eine dünne Schicht aus dem Gemisch, und zwar in der Größenordnung von 1 µm Dicke, auf dem Träger zurückbleibt. Diese Behandlung wird normalerweise bei Temperaturen im Bereich von etwa 20° bis 100° C, vorzugsweise bei etwa 50° bis 90° C, insbesondere bei etwa 70° bis 90° C, durchgeführt. Diese Behandlung wird so lange fortgesetzt, bis sich die Verdampfungsgeschwindigkeit des Lösemittels nur noch in relativ unbedeutendem Maße verändert. Die Wahl von Temperatur und Zeit richtet sich nach den vom Verbraucher verlangten Resisteigenschaften sowie nach den verwendeten Vorrichtungen und den gewünschten Beschichtungszeiten. Wirtschaftlich vertretbare Behandlungszeiten für die Behandlung auf einer Heizplatte betragen bis zu 3 Minuten, vorzugsweise bis zu 1 Minute. Zweckmäßig ist zum Beispiel eine Behandlung von 30 Sekunden bei 90° C.

Der beschichtete Träger kann in bekannter Weise mit aktinischer Strahlung, insbesondere mit UV-Strahlung, ganzflächig, d.h. nichtbildmäßig belichtet werden. Dabei kann eine Belichtung mit geringer Energie im Bereich von etwa 5 mJ/cm$^2$ bis 40 mJ/cm$^2$, vorzugsweise von etwa 20 mJ/cm$^2$ bis 30 mJ/cm$^2$, angewendet werden.

Anschließend wird die lichtempfindliche Basisschicht einer Nachbelichtungshärtung bzw. Wärmebehandlung bei etwa 90° bis 160° C, vorzugsweise bei 100° bis 150° C, insbesondere bei 115° bis 135° C, unterzogen. Diese Wärmebehandlung kann mit Hilfe eines Heizplattensystems oder in einem Konvektionsofen bei einer zur teilweisen Vernetzung des Gemischs ausreichenden Temperatur und Zeitdauer durchgeführt werden. Bei einem Heizplattensystem beträgt die Behandlungsdauer normalerweise etwa 5 bis 30 Sekunden, vorzugsweise etwa 10 bis 15 Sekunden. Bei einem Ofen kann die Wärmebehandlung etwa 15 Minuten dauern. Die Behandlungsdauer richtet sich nach den Bestandteilen des Gemischs, der Dicke der Schicht und dem verwendeten Träger.

Durch die Wärmebehandlung wird die Diazoverbindung in eine Carbonsäure, eine Indencarbonsäure, umgewandelt, die in wäßrig-alkalischen Lösungen löslich ist. Es ist deshalb wichtig, daß dieser Belichtungs-/Wärmebehandlungsschritt so durchgeführt wird, daß das Gemisch den weitaus größten Teil seiner Lichtempfindlichkeit beibehält.

Die Temperaturen und Behandlungszeiten bei der ersten und zweiten Wärmebehandlung können entsprechend den vom Endverbraucher gewünschten Eigenschaften gewählt und auf optimale Ergebnisse eingestellt werden.

Auf die lichtempfindliche Basisschicht wird eine zweite lichtempfindliche Schicht, die lichtempfindliche Deckschicht, enthaltend ein lichtempfindliches o-Chinondiazid, z.B. ein 1,2-Chinondiazid-4-oder -5-sulfonsäureester eines Phenolderivats und ein Novolak-und/oder Polyvinylphenolharz aufgebracht. Die genannten o-Chinondiazide sind bekannt und schließen die hier bereits beschriebenen o-Chinondiazide ein.

Die lichtempfindliche Deckschicht kann ebenfalls die schon erwähnten Additive, wie z.B. Farbmittel, Farbstoffe, Verlaufmittel, Weichmacher, Haftvermittler, Lösemittel, Entwicklungsbeschleuniger und Tenside enthalten. Die einzelnen Bestandteile müssen in solchen Anteilen in dem Gemisch enthalten sein, daß ein lichtempfindliches Gemisch entsteht, das sich nach der Belichtung mit aktinischer Strahlung im wesentlichen mit einem wäßrig-alkalischen Entwickler lösen läßt.

Beide lichtempfindliche Schichten sollen jeweils gegenüber aktinischer Strahlung unterschiedlicher Wellenlängen im Bereich des UV-Spektrums reaktionsfähig sein. Dies ist entweder durch die Wahl von Diazoverbindungen unterschiedlichen Absorptionsspektrums oder durch Zugabe von Additiven, wie z.B. Farbstoffen, in eine der beiden Schichten zu erreichen.

Die bildmäßige Belichtung des so hergestellten erfindungsgemäßen zweischichtigen Aufzeichnungsmaterials erfolgt mit aktinischer Strahlung in ausreichender Intensität und mit einer Wellenlänge, so daß sich die belichteten Bereiche der lichtempfindlichen Deckschicht in einem geeigneten Lösemittel lösen, ohne daß darüber hinaus die lichtempfindliche Basisschicht in nennenswertem Maße löslich wird.

Zum Entwickeln wird der belichtete Träger in eine geeignete Entwicklerlösung getaucht. Die Stärke des Entwicklers und die Entwicklungszeit sollen so gewählt werden, daß sich die untere Schicht nicht in nennenswerter Weise löst. Vorzugsweise wird die Lösung in Bewegung gehalten, z.B. durch Einblasen von Stickstoff. Das Aufzeichnungsmaterial bleibt so lange in dem Entwickler, bis die gesamten bzw. im wesentlichen gesamten belichteten Bereiche der lichtempfindlichen Deckschicht weggelöst sind. Geeignete Entwickler sind wäßrig-alkalische Lösungen, z.B. die bekannten Entwickler, die Natriumhydroxid oder Tetramethylammoniumhydroxid enthalten.

Das resultiernde Material enthält nun eine PCM-Maske auf der lichtempfindlichen Basisschicht. Dieses Material wird anschließend ganzflächig belichtet, und zwar mit aktinischer Strahlung in einer Intensität und mit einer Wellenlänge, die ausreicht, um die belichteten Bereiche der ersten lichtempfindlichen Schicht in einem geeigneten Entwickler löslich zu machen. Aufgrund ihrer optischen Dichte kann die PCM-Maske das auf sie auftreffende Licht absorbieren und die Belichtung der darunter liegenden Bereiche der ersten lichtempfindlichen Schicht verhindern. Entwickelt werden die belichteten Bereiche der Basisschicht in der Weise, in der auch die Deckschicht entwickelt worden ist.

Nachdem der beschichtete Wafer aus der Entwicklerlösung herausgenommen worden ist, kann gegebenfalls eine Wärmenachbehandlung bzw. Schichthärtungsbehandlung durchgeführt werden, um die Haftung der Beschichtung und ihre chemische Beständigkeit gegen Ätzlösungen und andere Substanzen zu erhöhen. Die Wärmebehandlung nach dem Entwickeln kann das Ofenhärten von Beschichtung und Träger unterhalb des Erweichungspunktes der Beschichtung umfassen.

Bei gewerblichen Anwendungen, insbesondere bei der Herstellung von Bauteilen für die Mikroschaltungstechnik auf Silicium/Siliciumdioxid-Trägern können die entwickelten Träger mit einer gepufferten Ätzlösung auf der Basis von Fluorwasserstoffsäure behandelt oder in einem trocken ätzenden Milieu verarbeitet werden. Das erfindungsgemäße, nachgehärtete Aufzeichnungsmaterial ist beständig gegen Ätzlösungen auf Säurebasis und bildet einen wirksamen Schutz für die unbelichteten Bereiche des Trägers.

In den folgenden Beispielen werden die Methoden zur Herstellung und Anwendung des erfindungsgemäßen Aufzeichnungsmaterials näher erläutert. Diese Beispiele sollen jedoch den Umfang der Erfindung in keiner Weise begrenzen oder einschränken, und sie sollen auch nicht so ausgelegt werden, als ob sie Bedingungen, Parameter oder Werte festlegen, die bei der Ausführung dieser Erfindung ausschließlich angewendet werden müssen.

Beispiel 1

Das lichtempfindliche Gemisch für die Deckschicht hat die folgende Zusammensetzung:

15,7 Gew.-% eines Kresol-Novolakharzes,
5,2 Gew.-% einer lichtempfindlichen Verbindung bestehend aus dem Kondensationsprodukt aus 2,3,4-Trihydroxybenzophenon und 1,2-Naphthochinondiazid-5-sulfonylchlorid,
76,7 Gew.-% Propylenglykolmonomethyletheracetat und
2,4 Gew.-% Bipyridylethylen-Farbstoff.

Das lichtempfindliche Gemisch für die Basisschicht setzt sich wie folgt zusammen:

23,1 Gew.-% eines Kresol-Novolakharzes,
3,0 Gew.-% 2,3,4-Trihydroxybenzophenon-1,2-naphthochinondiazid-4-sulfonsäuretrisester,
72,9 Gew.-% Propylenglykolmonomethyletheracetat und
1,0 Gew.-% Dimethylolparakresol.

Mit dem lichtempfindlichen Gemisch für die Basisschicht werden Siliciumwafer bei 2.000 U/min - schleuderbeschichtet und anschließend in einem Umluftkonvektionsofen bei 90° C für 30 Minuten thermisch konditioniert. Anschließend wird mit einem Belichtungsgerät Modell 8089 von Oriel eine ganzflächige Breitbandbelichtung (Breitbandflutbelichtung) durchgeführt. Die mit einem Radiometer von Optical Applied Inc. ermittelte Belichtungsenergie für Wellenlängen zwischen 365 und 436 nm beträgt 30 mJ/cm². Die beschichteten Wafer werden in einem Umluftkonvektionsofen für die Dauer von 15 Minuten bei 125° C einer Nachbelichtungshärtung unterzogen. Nach dem Abkühlen der Wafer auf Raumtemperatur werden diese bei 2.000 U/min mit dem lichtempfindlichen Gemisch für die Deckschicht schleu-derbeschichtet und diese dann in einem Umluftkonvektionsofen bei 90° C für 30 Minuten thermisch konditioniert.

Für die bildmäßige Belichtung durch eine Glasphotomaske mit einem Auflösungs-Testleiterbild wird das Belichtungsgerät "Perkin Elmer 220 Micralign" verwendet. Die mit dem Radiometer von OAI ermittelte Belichtungsenergie für Wellenlängen zwischen 365 und 436 nm beträgt 180 mJ/cm².

Nach dem Tauchentwickeln der belichteten Wafer in einem im Verhältnis 1:3 mit Wasser verdünnten Natriumhyroxid enthaltenden Entwickler für die Dauer von 90 Sekunden bei leichter Badbewegung werden die Wafer mit entmineralisiertem Wasser gespült und trockengeschleudert.

Die Wafer werden nun unter einem Rasterelektronenmikroskop bei 10.000facher Vergrößerung untersucht. Dabei zeigt sich deutlich, daß ein isolierter Graben von 2 µm und größere Strukturen durch die Deckschicht hindurch vollständig aufgelöst sind. Das Bild auf der Deckschicht kann jetzt als PCM-Maske für die Bebilderung der Basisschicht verwendet werden.

Die aktinische Wellenlänge für die Belichtung der Basisschicht beträgt 300 bis 400 nm. Die Wafer werden mit einem "Deep UV"-Belichtungsgerät, Modell 29D, von OAI mit einem Bandfilter für 310 nm ganzflächig belichtet. Die mit dem Radiometer von OAI für eine Wellenlänge von 310 nm ermittelte Belichtungsenergie beträgt 126 mJ/cm². Die Wafer werden anschließend in einem metallionenfreien Entwickler, enthaltend Tetramethylammoniumhydroxid, für 180 Sekunden bei leichter Badbewegung tauchentwickelt. Sie werden sofort mit entmineralisiertem Wasser gespült und trockengeschleudert.

Die Wafer werden erneut unter dem Rasterelektronenmikroskop bei 10.000facher Vergrößerung untersucht. Dabei zeigt sich deutlich, daß ein isolierter Graben von 2 µm und größere Strukturen vollständig aufgelöst sind.

Beispiel 2

Das lichtempfindliche Gemisch für die Deckschicht hat die folgende Zusammensetzung:

15,7 Gew.-% eines Kresol-Novolakharzes,
5,2 Gew.-% einer lichtempfindlichen Verbindung bestehend aus dem Kondensationsprodukt aus 2,3,4-Trihydroxybenzophenon und 1,2-Naphthochinondiazid-5-sulfonylchlorid,
76,7 Gew.-% Propylenglykolmonomethyletheracetat und
2,4 Gew.-% Bipyridylethylen-Farbstoff.

Das lichtempfindliche Gemisch für die Basisschicht setzt sich wie folgt zusammen:

23,0 Gew.-% eines Kresol-Novolakharzes,
3,0 Gew.-% Trihydroxyphenyloctylketon-1,2-naphthochinondiazid-4-sulfonsäuretrisester,
1,3 Gew.-% 2,6-Dimethylolparakresol und
72,7 Gew.-% Propylenglykolmonomethyletheracetat.

Mit dem lichtempfindlichen Gemisch für die Basisschicht werden Siliciumwafer bei 2.000 U/min - schleuderbeschichtet und anschließend in einem Umluftkonvek-tionsofen bei 90° C für 30 Minuten thermisch konditioniert. Anschließend wird mit einem Belichtungsgerät Modell 8089 von Oriel eine ganzflächige Breitbandbelichtung (Breitbandflutbelichtung) durchgeführt. Die mit einem Radiometer von Optical Applied Inc. ermittelte Belichtungsenergie für Wellenlängen zwischen 365 und 436 nm beträgt 10 $mJ/cm^2$. Die beschichteten Wafer werden in einem Umluftkonvektionsofen für die Dauer von 15 Minuten bei 125° C einer Nachbelichtungshärtung unterzogen. Nach dem Abkühlen der Wafer auf Raumtemperatur werden diese bei 3.000 U/min mit dem lichtempfindlichen Gemisch für die Deckschicht schleuderbeschichtet und diese dann in einem Umluftkonvektionsofen bei 90° C für 30 Minuten thermisch konditioniert.

Für die bildmäßige Belichtung durch eine Glasphotomaske mit einem Auflösungs-Testleiterbild wird das Belichtungsgerät "Perkin Elmer 220 Micralign" verwendet. Die mit dem Radiometer von OAI ermittelte Belichtungsenergie für Wellenlängen zwischen 365 und 436 nm beträgt 250 $mJ/cm^2$.

Nach dem Tauchentwickeln der belichteten Wafer in einem im Verhältnis 1:3 mit Wasser verdünnten Natriumhydroxid enthaltenden Entwickler für die Dauer von 90 Sekunden bei leichter Badbewegung werden die Wafer mit entmineralisiertem Wasser gespült und trockengeschleudert.

Die Wafer werden nun unter einem Rasterelektronenmikroskop bei 10.000facher Vergrößerung untersucht. Dabei zeigt sich deutlich, daß ein isolierter Graben von 2 µm und größere Strukturen durch die Deckschicht hindurch vollständig aufgelöst sind. Das Bild auf der Deckschicht kann jetzt als PCM-Maske für die Bebilderung der Basisschicht verwendet werden.

Die aktinische Wellenlänge für die Belichtung der Basisschicht beträgt 300 bis 400 nm. Die Wafer werden mit einem "Deep UV"-Belichtungsgerät, Modell 29D, von OAI mit einem Bandfilter für 310 nm ganzflächig belichtet. Die mit dem Radiometer von OAI für eine Wellenlänge von 310 nm ermittelte Belichtungsenergie beträgt 200 $mJ/cm^2$. Die Wafer werden anschließend in einem metallionenfreien Entwickler, enthaltend Tetramethylammoniumhydroxid, für 180 Sekunden bei leichter Badbewegung tauchentwickelt. Sie werden sofort mit entmineralisiertem Wasser gespült und trockengeschleudert.

Die Wafer werden erneut unter dem Rasterelektronenmikroskop bei 10.000facher Vergrößerung untersucht. Dabei zeigt sich deutlich, daß ein isolierter Graben von 2 µm und größere Strukturen vollständig aufgelöst sind.

## Beispiel 3

Das lichtempfindliche Gemisch für die Deckschicht hat die folgende Zusammensetzung:

12,6 Gew.-% eines Kresol-Novolakharzes,
4,1 Gew.-% einer lichtempfindlichen Verbindung bestehend aus dem Kondensationsprodukt aus 2,3,4-Trihydroxybenzophenon und 1,2-Naphthochinondiazid-5-sulfonylchlorid,
79,3 Gew.-% Propylenglykolmonomethyletheracetat und
4,0 Gew.-% Bipyridylethylen-Farbstoff.

Das lichtempfindliche Gemisch für die Basisschicht setzt sich wie folgt zusammen:

23,0 Gew.-% eines Kresol-Novolakharzes,
3,1 Gew.-% 2,3,4-Trihydroxyphenylundecylketon-1,2-naphthochinondiazid-4-sulfonsäuretrisester,
1,3 Gew.-% 2,6-Dimethylolparakresol und
72,6 Gew.-% Propylenglykolmonomethyletheracetat.

Mit dem lichtempfindlichen Gemisch für die Basisschicht werden Siliciumwafer bei 2.000 U/min - schleuderbeschichtet und anschließend in einem Umluftkonvektionsofen bei 90° C für 30 Minuten thermisch konditioniert. Anschließend wird mit einem Belichtungsgerät Modell 8089 von Oriel eine ganzflächige Breitbandbelichtung (Breitbandflutbelichtung) durchgeführt. Die mit einem Radiometer von Optical Applied Inc. ermittelte Belichtungsenergie für Wellen längen zwischen 365 und 436 nm beträgt 10 $mJ/cm^2$. Die beschichteten Wafer werden in einem Umluftkonvektionsofen für die Dauer von 15 Minuten bei 125° C einer Nachbelichtungshärtung unterzogen. Nach dem Abkühlen der Wafer auf Raumtemperatur werden diese bei 3.000 U/min mit dem lichtempfindlichen Gemisch für die Deckschicht schleuderbeschichtet und diese dann in einem Umluftkonvektionsofen bei 90° C für 30 Minuten thermisch konditioniert.

Für die bildmäßige Belichtung durch eine Glasphotomaske mit einem Auflösungs-Testleiterbild wird das Belichtungsgerät "Perkin Elmer 220 Micralign" verwendet. Die mit dem Radiometer von OAI ermittelte Belichtungsenergie für Wellenlängen zwischen 365 und 436 nm beträgt 250 mJ/cm².

Nach dem Tauchentwickeln der belichteten Wafer in einem im Verhältnis 1:3 mit Wasser verdünnten Natriumhydroxid enthaltenden Entwickler für die Dauer von 60 Sekunden bei leichter Badbewegung werden die Wafer mit entmineralisiertem Wasser gespült und trockengeschleudert.

Die Wafer werden nun unter einem Rasterelektronenmikroskop bei 10.000facher Vergrößerung untersucht. Dabei zeigt sich deutlich, daß ein isolierter Graben von 2 µm und größere Strukturen durch die Deckschicht hindurch vollständig aufgelöst sind. Das Bild auf der Deckschicht kann jetzt als PCM-Maske für die Bebilderung der Basisschicht verwendet werden.

Die aktinische Wellenlänge für die Belichtung der Basisschicht beträgt 300 bis 400 nm. Die Wafer werden mit einem "Deep UV"-Belichtungsgerät, Modell 29D, von OAI mit einem Bandfilter für 310 nm ganzflächig belichtet. Die mit dem Radiometer von OAI für eine Wellenlänge von 310 nm ermittelte Belichtungsenergie beträgt 300 mJ/cm². Die Wafer werden anschließend in dem im Verhältnis 2:1 verdünnten metallionenfreien Entwickler, enthaltend Tetramethylammoniumhydroxid, für 180 Sekunden bei leichter Badbewegung tauchentwickelt. Sie werden sofort mit entmineralisiertem Wasser gespült und trockengeschleudert.

Die Wafer werden erneut unter dem Rasterelektronenmikroskop bei 10.000facher Vergrößerung untersucht. Dabei zeigt sich deutlich, daß ein isolierter Graben von 2 µm und größere Strukturen vollständig aufgelöst sind.

Beispiel 4

Das aus US-A 4,588,670 bekannte lichtempfindliche Gemisch für die Deckschicht hat die folgende Zusammensetzung:

14,7 Gew.-% eines Kresol-Novolakharzes,
3,7 Gew.-% 2,3,4-Trihydroxyphenylheptylketon-1,2-naphthochinondiazid-5-sulfonsäuretrisester,
79,6 Gew.-% Propylenglykolmonomethyletheracetat und
2,0 Gew.-% 4,4'-Bipyridylethylen-Farbstoff.

Das lichtempfindliche Gemisch für die Basisschicht setzt sich wie folgt zusammen:

23,0 Gew.-% eines Kresol-Novolakharzes,
3,0 Gew.-% 2,3,4-Trihydroxybenzophenon-1,2-naphthochinondiazid-4-sulfonsäuretrisester,
1,8 Gew.-% Cymel 325-Harz (American Cyanamid) und
72,2 Gew.-% Propylenglykolmonomethyletheracetat.

Mit dem lichtempfindlichen Gemisch für die Basisschicht werden Siliciumwafer bei 2.000 U/min - schleuderbeschichtet und dann in einem Umluftkonvektionsofen bei 90° C für 30 Minuten thermisch konditioniert. Die beschichteten Wafer werden anschließend noch in einem Umluftkonvektionsofen für die Dauer von 10 Minuten bei 100° C nachgehärtet. Nach dem Abkühlen der Wafer auf Raumtemperatur werden diese bei 2.000 U/min mit dem lichtempfindlichen Gemisch für die Deckschicht schleu-derbeschichtet und diese dann in einem Umluftkonvektionsofen bei 90° C für 30 Minuten thermisch konditioniert.

Für die bildmäßige Belichtung durch eine Glasphotomaske mit einem Auflösungs-Testleiterbild wird das Belichtungsgerät "Perkin Elmer 220 Micralign" verwendet. Die mit einem Radiometer von OAI ermittelte Belichtungsenergie für Wellenlängen zwischen 365 und 436 nm beträgt 175 mJ/cm².

Nach dem Tauchentwickeln der belichteten Wafer in einem im Verhältnis 1:3 mit Wasser verdünnten Natriumhydroxid enthaltenden Entwickler für die Dauer von 60 Sekunden bei leichter Badbewegung werden die Wafer mit entmineralisiertem Wasser gespült und trockengeschleudert.

Die Wafer werden nun unter einem Rasterelektronenmikroskop bei 10.000facher Vergrößerung untersucht. Dabei zeigt sich deutlich, daß ein isolierter Graben von 2 µm und größere Strukturen durch die Deckschicht hindurch vollständig aufgelöst sind. Das Bild auf der Deckschicht kann jetzt als PCM-Maske für die Bebilderung der Basisschicht verwendet werden.

Die aktinische Wellenlänge für die Belichtung der Basisschicht beträgt 300 bis 400 nm. Die Wafer werden mit einem "Deep UV"-Belichtungsgerät, Modell 29D, von OAI mit einem Bandfilter für 310 nm ganzflächig belichtet. Die mit dem Radiometer von OAI für eine Wellenlänge von 310 nm ermittelte Belichtungsenergie beträgt 150 $mJ/cm^2$. Die Wafer werden anschließend in dem im Verhältnis 2:1 verdünnten metallionenfreien Entwickler, enthaltend Tetramethylammoniumhydroxid, für 60 Sekunden bei leichter Badbewegung tauchentwickelt. Sie werden sofort mit entmineralisiertem Wasser gespült und trockengeschleudert.

Die Wafer werden erneut unter dem Rasterelektronenmikroskop bei 10.000facher Vergrößerung untersucht. Dabei zeigt sich deutlich, daß ein isolierter Graben von 2 µm und größere Strukturen vollständig aufgelöst sind.

## Beispiel 5

Das aus US-A 4,588,670 bekannte lichtempfindliche Gemisch für die Deckschicht hat die folgende Zusammensetzung:

14,7 Gew.-% eines Kresol-Novolakharzes,
3,7 Gew.-% 2,3,4-Trihydroxyphenylheptylketon-1,2-naphthochinondiazid-5-sulfonsäuretrisester,
79,6 Gew.-% Propylenglykolmonomethyletheracetat und
2,0 Gew.-% 4,4'-Bipyridylethylen-Farbstoff.

Das lichtempfindliche Gemisch für die Basisschicht setzt sich wie folgt zusammen:

23,0 Gew.-% eines Kresol-Novolakharzes,
3,0 Gew.-% 2,3,4-Trihydroxyphenyloctylketon-1,2-naphthochinondiazid-4-sulfonsäuretrisester,
1,8 Gew.-% Cymel 325-Harz (American Cyanamid) und
72,2 Gew.-% Propylenglykolmonomethyletheracetat.

Mit dem lichtempfindlichen Gemisch für die Basisschicht werden Siliciumwafer bei 2.000 U/min schleuderbeschichtet und dann in einem Umluftkonvektionsofen bei 90° C für 30 Minuten thermisch konditioniert. Anschließend wird mit einem Belichtungsgerät Modell 8089 von Oriel eine ganzflächige Breitbandbelichtung (Breitbandflutbelichtung) durchgeführt. Die mit einem Radiometer von Optical Applied Inc. ermittelte Belichtungsenergie für Wellenlängen zwischen 365 und 436 nm beträgt 5 $mJ/cm^2$. Die beschichteten Wafer werden anschließend noch in einem Umluftkonvektionsofen für die Dauer von 10 Minuten bei 100° C einer Nachbelichtungshärtung unterzogen. Nach dem Abkühlen der Wafer auf Raumtemperatur werden diese bei 2.000 U/min mit dem lichtempfindlichen Gemisch für die Deckschicht schleuderbeschichtet und diese dann in einem Umluftkonvektionsofen bei 90° C für 30 Minuten thermisch konditioniert.

Für die bildmäßige Belichtung durch eine Glasphotomaske mit einem Auflösungs-Testleiterbild wird das Belichtungsgerät "Perkin Elmer 220 Micralign" verwendet. Die mit einem Radiometer von OAI ermittelte Belichtungsenergie für Wellenlängen zwischen 365 und 436 nm beträgt 175 $mJ/cm^2$.

Nach dem Tauchentwickeln der belichteten Wafer in den im Verhältnis 1:3 mit Wasser verdünnten Natriumhydroxid enthaltenden Entwickler für die Dauer von 70 Sekunden bei leichter Badbewegung werden die Wafer mit entmineralisiertem Wasser gespült und trockengeschleudert.

Die Wafer werden nun unter einem Rasterelektronenmikroskop bei 10.000facher Vergrößerung untersucht. Dabei zeigt sich deutlich, daß ein isolierter Graben von 2 µm und größere Strukturen durch die Deckschicht hindurch vollständig aufgelöst sind. Das Bild auf der Deckschicht kann jetzt als PCM-Maske für die Bebilderung der Basisschicht verwendet werden.

Die aktinische Wellenlänge für die Belichtung der Basisschicht beträgt 300 bis 400 nm. Die Wafer werden mit einem "Deep UV"-Belichtungsgerät, Modell 29D, von OAI mit einem Bandfilter für 310 nm ganzflächig belichtet. Die mit dem Radiometer von OAI für eine Wellenlänge von 310 nm ermittelte Belichtungsenergie beträgt 200 $mJ/cm^2$. Die Wafer werden anschließend in dem im Verhältnis 2:1 verdünnten metallionenfreien Entwickler, enthaltend Tetramethylammoniumhydroxid, für 5 Minuten bei leichter Badbewegung tauchentwickelt. Sie werden sofort mit entmineralisiertem Wasser gespült und trockengeschleudert.

Die Wafer werden erneut unter dem Rasterelektronenmikroskop bei 10.000facher Vergrößerung untersucht. Dabei zeigt sich deutlich, daß ein isolierter Graben von 2 µm und größere Strukturen vollständig aufgelöst sind.

Beispiel 6

Das aus US-A 4,588,670 bekannte lichtempfindliche Gemisch für die Deckschicht hat die folgende Zusammensetzung:

14,7 Gew.-% eines Kresol-Novolakharzes,
3,7 Gew.-% 2,3,4-Trihydroxyphenylheptylketon-1,2-naphthochinondiazid-5-sulfonsäuretrisester,
79,6 Gew.-% Propylenglykolmonomethyletheracetat und
2,0 Gew.-% 4,4'-Bipyridylethylen-Farbstoff.

Das lichtempfindliche Gemisch für die Basisschicht setzt sich wie folgt zusammen:

23,0 Gew.-% eines Kresol-Novolakharzes,
3,0 Gew.-% 2,3,4-Trihydroxyphenylnonylketon-1,2-naphthochinondiazid-4-sulfonsäuretrisester,
1,8 Gew.-% Cymel 325-Harz (American Cyanamid) und
72,2 Gew.-% Propylenglykolmonomethyletheracetat.

Mit dem lichtempfindlichen Gemisch für die Basisschicht werden Siliciumwafer bei 2.000 U/min - schleuderbeschichtet und dann in einem Umluftkonvektionsofen bei 90° C für 30 Minuten thermisch konditioniert. Anschließend wird mit einem Belichtungsgerät Modell 8089 von Oriel eine ganzflächige Breitbandbelichtung (Breitbandflutbelichtung) durchgeführt. Die mit einem Radiometer von Optical Applied Inc. ermittelte Belichtungsenergie für Wellenlängen zwischen 365 und 436 nm beträgt 5 mJ/cm². Die beschichteten Wafer werden anschließend noch in einem Umluftkonvektionsofen für die Dauer von 10 Minuten bei 100° C einer Nachbelichtungshärtung unterzogen. Nach dem Abkühlen der Wafer auf Raumtemperatur werden diese bei 2.000 U/min mit dem lichtempfindlichen Gemisch für die Deckschicht schleuderbeschichtet und diese dann in einem Umluftkonvektionsofen bei 90° C für 30 Minuten thermisch konditioniert.

Für die bildmäßige Belichtung durch eine Glasphotomaske mit einem Auflösungs-Testleiterbild wird das Belichtungsgerät "Perkin Elmer 220 Micralign" verwendet. Die mit einem Radiometer von OAI ermittelte Belichtungsenergie für Wellenlängen zwischen 365 und 436 nm beträgt 175 mJ/cm².

Nach dem Tauchentwickeln der belichteten Wafer in dem im Verhältnis 1:3 mit Wasser verdünnten Natriumhydroxid enthaltenden Entwickler für die Dauer von 70 Sekunden bei leichter Badbewegung werden die Wafer mit entmineralisiertem Wasser gespült und trockengeschleudert.

Die Wafer werden nun unter einem Rasterelektronenmikroskop bei 10.000facher Vergrößerung untersucht. Dabei zeigt sich deutlich, daß ein isolierter Graben von 2 µm und größere Strukturen durch die Deckschicht hindurch vollständig aufgelöst sind. Das Bild auf der Deckschicht kann jetzt als PCM-Maske für die Bebilderung der Basisschicht verwendet werden.

Die aktinische Wellenlänge für die Belichtung der Basisschicht beträgt 300 bis 400 nm. Die Wafer werden mit einem "Deep UV"-Belichtungsgerät, Modell 29D, von OAI mit einem Bandfilter für 310 nm ganzflächig belichtet. Die mit dem Radiometer von OAI für eine Wellenlänge von 310 nm ermittelte Belichtungsenergie beträgt 270 mJ/cm². Die Wafer werden anschließend in dem im Verhältnis 2:1 verdünnten metallionenfreien Entwickler, enthaltend Tetramethylammoniumhydroxid, für 60 Sekunden bei leichter Badbewegung tauchentwickelt. Sie werden sofort mit entmineralisiertem Wasser gespült und trockengeschleudert.

Die Wafer werden erneut unter dem Rasterelektronenmikroskop bei 10.000facher Vergrößerung untersucht. Dabei zeigt sich deutlich, daß ein isolierter Graben von 2 µm und größere Strukturen vollständig aufgelöst sind.

Beispiel 7

Das lichtempfindliche Gemisch für die Deckschicht hat die folgende Zusammensetzung:

15,7 Gew.-% eines Kresol-Novolakharzes,
5,2 Gew.-% einer lichtempfindlichen Verbindung bestehend aus dem Kondensationsprodukt aus 2,3,4-Trihydroxybenzophenon und 1,2-Naphthochinondiazid-5-sulfylchlorid ,
76,7 Gew.-% Propylenglykolmonomethyletheracetat und
2,4 Gew.-% Bipyridylethylen-Farbstoff.

Das lichtempfindliche Gemisch für die Basisschicht setzt sich wie folgt zusammen:

23,1 Gew.-% eines Kresol-Novolakharzes,
3,0 Gew.-% des Kondensationsprodukts aus 2,3,4-Trihydroxybenzophenon und einer Mischung im Verhältnis 90:10 von 1,2-Naphthochinondiazid-4-sulfonylchlorid und 1,2-Naphthochinondiazid-5-sulfonylchlorid,
1,0 Gew.-% Dimethylolparakresol,
0,9 Gew.-% gelber Farbstoff "Macrolex" (Mobay Chemical Co.)
72,0 Gew.-% Propylenglykolmonomethyletheracetat.

Mit dem lichtempfindlichen Gemisch für die Basisschicht werden Siliciumwafer bei 2.000 U/min - schleuderbeschichtet und dann in einem Umluftkonvektionsofen bei 90° C für 30 Minuten thermisch konditioniert. Anschließend wird mit einem Belichtungsgerät Modell 8089 von Oriel eine ganzflächige Breitbandbelichtung (Breitbandflutbelichtung) durchgeführt. Die mit einem Radiometer von Optical Applied Inc. ermittelte Belichtungsenergie für Wellenlängen zwischen 365 und 436 nm beträgt 30 mJ/cm². Die beschichteten Wafer werden anschließend noch in einem Umluftkonvektionsofen für die Dauer von 15 Minuten bei 120° C einer Nachbelichtungshärtung unterzogen. Nach dem Abkühlen der Wafer auf Raumtemperatur werden diese bei 2.000 U/min mit dem lichtempfindlichen Gemisch für die Deckschicht schleuderbeschichtet und diese dann in einem Umluftkonvektionsofen bei 90° C für 30 Minuten thermisch konditioniert.

Für die bildmäßige Belichtung durch eine Glasphotomaske mit einem Auflösungs-Testleiterbild wird das Belichtungsgerät "TRE G-Line Stepper" verwendet. Die Belichtungsenergie beträgt 300 mJ/cm².

Nach dem Tauchentwickeln der belichteten Wafer in dem im Verhältnis 1:3 mit Wasser verdünnten Natriumhydroxid enthaltenden Entwickler für die Dauer von 90 Sekunden bei leichter Badbewegung werden die Wafer mit entmineralisiertem Wasser gespült und trockengeschleudert.

Die Wafer werden nun unter einem Rasterelektronenmikroskop bei 10.000facher Vergrößerung untersucht. Dabei zeigt sich deutlich, daß ein isolierter Graben von 2 µm und größere Strukturen durch die Deckschicht hindurch vollständig aufgelöst sind. Das Bild auf der Deckschicht kann jetzt als PCM-Maske für die Bebilderung der Basisschicht verwendet werden.

Die aktinische Wellenlänge für die Belichtung der Basisschicht beträgt 300 bis 400 nm. Die Wafer werden mit einem "Deep UV"-Belichtungsgerät, Modell 29D, von OAI mit einem Bandfilter für 310 nm ganzflächig belichtet. Die mit dem Radiometer von OAI für eine Wellenlänge von 310 nm ermittelte Belichtungsenergie beträgt 120 mJ/cm². Die Wafer werden anschließend in dem im Verhältnis 5:1 mit Wasser verdünnten metallionenfreien Entwickler, enthaltend Tetramethylammoniumhydroxid, für 180 Sekunden bei leichter Badbewegung tauchentwickelt. Sie werden sofort mit entmineralisiertem Wasser gespült und trockengeschleudert.

Die Wafer werden erneut unter dem Rasterelektronenmikroskop bei 10.000facher Vergrößerung untersucht. Dabei zeigt sich deutlich, daß ein isolierter Graben von 2 µm und größere Strukturen vollständig aufgelöst sind.

## Ansprüche

1. Mehrschichtiges positiv arbeitendes lichtempfindliches Aufzeichnungsmaterial, im wesentlichen bestehend aus einem Träger und zwei darauf aufgebrachten, positiv arbeitenden lichtempfindlichen Schichten, dadurch gekennzeichnet, daß die lichtempfindliche Basisschicht

A) als lichtempfindliche Verbindung eine Verbindung der allgemeinen Formel I

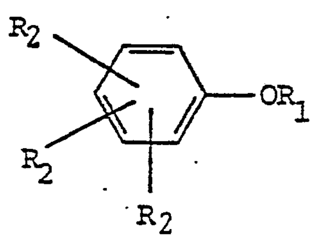

(I)

enthält, worin

$R_1$ 1,2-Benzochinondiazid-4-sulfonyl; 1,2-Naphthochinondiazid-4-sulfonyl oder 1,2-Anthrachinondiazid-4-sulfonyl sowie

$R_2$ gleich oder verschieden sein können und Wasserstoff, Hydroxy, O-$R_3$, $R_4$ oder - $\overset{O}{\overset{\|}{C}}$ -$R_4$ und
$R_3$ Alkyl, Aryl, Aralkyl oder $R_1$ sowie
$R_4$ Alkyl, Aryl oder Aralkyl

bedeuten oder eine Verbindung der allgemeinen Formel II

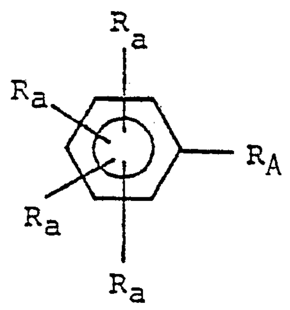

(II)

enthält, worin

$R_A$ Wasserstoff, -X-$R_b$ oder,

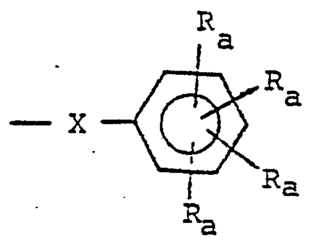

,

X eine Einfachbindung C-C, -O-, -S-, -$SO_2$-, - $\overset{O}{\overset{\|}{C}}$ -, - $\overset{O}{\overset{\|}{C}}$ -$(CH_2)_n$, -$CH_2$- $\overset{O}{\overset{\|}{C}}$ -$(CH_2)_n$-, - $\overset{O}{\overset{\|}{C}}$ -O-, - $\overset{O}{\overset{\|}{C}}$ -O-$(CH_2)_n$-, $CH_2$- $\overset{O}{\overset{\|}{C}}$ -O-$(CH_2)_n$-, -$(CH_2)_n$-oder $CH_3$- $\overset{|}{\underset{|}{C}}$ -$CH_3$, wobei n für 1 oder 2 steht,
$R_a$ Wasserstoff, -OH, -OY, -OZ, $R_A$, Halogen, oder eine niedere Alkylgruppe, wobei mindestens eine Gruppe $R_a$ -OY und mindestens eine Gruppe $R_a$-OZ ist, und
$R_b$Wasserstoff, eine substituierte oder unsubstituierte Alkyl-, Aryl-oder Aralkylgruppe

bedeuten, oder eine Verbindung der allgemeinen Formel III

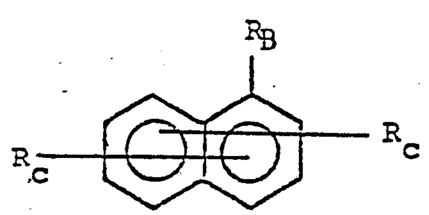

(III)

enthält, worin

R $_B$ Wasserstoff oder

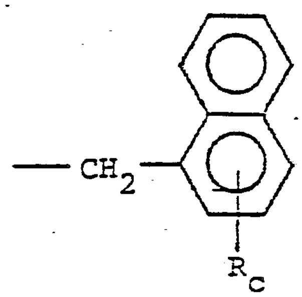

und

$R_c$ Wasserstoff, -OH, -OY oder -OZ ist, wobei mindestens eine Gruppe $R_c$ -OY und mindestens eine Gruppe $R_c$ -OZ

bedeuten, oder eine Verbindung der allgemeinen Formel IV

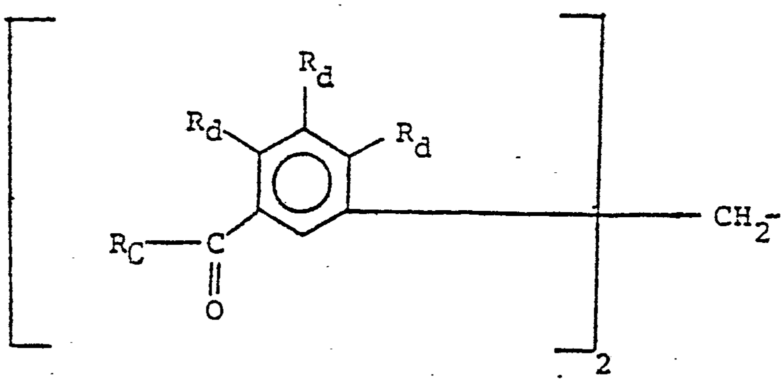
(IV)

enthält, worin

$R_C$ Wasserstoff, eine substituierte oder unsubstituierte Alkyl-oder Arylgruppe und
$R_d$ -OH, -OY oder -OZ ist, wobei mindestens eine Gruppe $R_d$ -OY und mindestens eine Gruppe $R_d$-OZ sowie

in den Verbindungen der allgemeinen Formeln II bis IV

Y 1,2-Naphthochinondiazid-4-sulfonyl und
Z 1,2-Naphthochinondiazid-5-sulfonyl oder $-W-R_5$, wobei
W -CO-oder $-SO_2$-und
$R_5$ substituiertes oder unsubstituiertes Alkyl oder Aryl

bedeuten, sowie
B) als Bindemittel ein Novolak und/oder ein Polyvinylphenol,
C) ein Vernetzungsmittel und
D) ein Lösemittel
enthält.

2. Lichtempfindliches Aufzeichnungsmaterial nach Anspruch 1, dadurch gekennzeichnet, daß die lichtempfindlichen Verbindungen A) der allgemeinen Formeln I, II, III oder IV in der Basisschicht zu 1 bis 25 Gew.-%, bezogen auf den Feststoffgehalt der lichtempfindlichen Basisschicht, enthalten sind.

3. Lichtempfindliches Aufzeichnungsmaterial nach den Ansprüchen 1 oder 2, dadurch gekennzeichnet, daß das Bindemittel B) zu 75 bis 99 Gew.-%, bezogen auf den Feststoffgehalt der lichtempfindlichen Basisschicht, in dieser Schicht enthalten ist.

4. Lichtempfindliches Aufzeichnungsmaterial nach einem oder mehreren der Ansprüche 1 bis 3, dadurch gekennzeichnet, daß das Vernetzungsmittel C) zu 0,5 bis 20 Gew.-%, bezogen auf den Feststoffgehalt der lichtempfindlichen Basisschicht, in dieser Schicht enthalten ist.

5. Verfahren zur Herstellung eines positiv arbeitenden mehrschichtigen Aufzeichnungsmaterials, gekennzeichnet durch folgende Schritte:

a) Herstellung eines lichtempfindlichen Gemischs für die Basisschicht, enthaltend eine der lichtempfindlichen Verbindungen der allgemeinen Formeln I bis IV, als Bindemittel ein Novolak und/oder ein Polyvinylphenolharz, ein Vernetzungsmittel, das in Anwesenheit der bei der Belichtung entstehenden Säure und/oder unter Wärmezufuhr befähigt ist, das Gemisch zu vernetzen, sowie ein Lösemittel,

b) Beschichten des Trägers mit diesem lichtempfindlichen Gemisch sowie Trocknen, so daß eine nicht klebrige lichtempfindliche Basisschicht entsteht,

c) ganzflächiges, nicht bildmäßiges Belichten der Basisschicht mit aktinischer Strahlung und Wärmezufuhr, um die Schicht teilweise zu vernetzen, ohne jedoch die Lichtempfindlichkeit der Schicht im wesentlichen zu verringern,

d) Beschichten der vernetzten lichtempfindlichen Basisschicht mit einem weiteren positiv arbeitenden lichtempfindlichen Gemisch, enthaltend ein o-Chinondiazid, als Bindemittel ein Novolakharz und/oder ein Polyvinylphenolharz (= lichtempfindliche Deckschicht),

e) Bildmäßiges Belichten der lichtempfindlichen Deckschicht mit für diese Schicht geeigneter aktinischen Strahlung und Entwickeln zu einer Bildmaske,

f) Belichten der lichtempfindlichen Basisschicht mit für diese Schicht geeigneter aktinischer Strahlung und Entwickeln der belichteten Bereiche auch dieser Schicht.

6. Verfahren nach Anspruch 5, dadurch gekennzeichnet, daß Schritt b) bei einer Temperatur von 20 bis 100° C erfolgt.

7. Verfahren nach Anspruch 5, dadurch gekennzeichnet, daß Schritt c) mit einer Belichtungsenergie von 5 bis 50 $mJ/cm^2$ erfolgt.

8. Verfahren nach den Ansprüchen 5 oder 7, dadurch gekennzeichnet, daß Schritt c) bei einer Temperatur von 90 bis 160° C erfolgt.

9. Verfahren nach Anspruch 5, dadurch gekennzeichnet, daß die Belichtungsschritte e) und f) bei unterschiedlichen Wellenlängen des UV-Lichtes erfolgt.

10. Verfahren nach Anspruch 9, dadurch gekennzeichnet, daß Belichtungsschritt e) bei einer Wellenlänge von 300 bis 410 nm erfolgt.